# EUROPEAN PATENT APPLICATION

(11) **EP 1 544 914 A2**
(43) Date of publication of application: **22.06.2005**
(21) Application number: 04029837.4
(22) Date of filing: 16.12.2004
(51) Int. Cl.: H01L 23/31

(54) **Semiconductor device and method of manufacturing thereof**

(30) Priority: 17.12.2003 JP 2003419405
(71) Applicant: SEIKO EPSON CORPORATION, Shinjuku-ku, Tokyo 163-0811 (JP)
(72) Inventor: Ito, Haruki, Suwa-shi Nagano-ken 392-8502 (JP)
(74) Representative: HOFFMANN - EITLE

(57) **Abstract**

The object of the invention disclosed here is the provision of a semiconductor device and a method of manufacturing thereof in which wirings and external terminals can be formed with high density, a circuit substrate and an electronic apparatus in which the semiconductor device is installed. The invention provides a semiconductor device (1), comprising a semiconductor element (2) including a plurality of electrodes (9), a plurality of resin layers, a plurality of wirings electrically coupled to the electrodes, and a plurality of external terminals electrically coupled to the wirings. A first wiring (4a), a part of the wirings (4), is formed at the bottom of a single resin layer (a first resin layer (3)) or a plurality of multiple-deposited resin layers. A second wiring (4b), excluding the above part of the wirings (4), is formed on the surface of the single resin layer (the first resin layer (3)) or a plurality of multiple-deposited resin layers.

## Description

### Technical Field

The present invention relates a semiconductor device and a method of manufacturing thereof, a circuit substrate and an electronic apparatus. It relates, in particular, a semiconductor device and a method of manufacturing thereof in which many external terminals can be formed and circuit substrate and a electronic apparatus in which the semiconductor device is installed.

### Background of the invention

In order to mounting a semiconductor device with high density, it is preferable to mount a semiconductor chip as it is without packaging such as bare mounting. In the bare chip mounting, however, it is insufficient to protect a semiconductor chip and hard to handle it. Hence, a semiconductor device using a chip size package (CSP) is proposed and a wafer level CSP in which a diced wafer becomes a semiconductor device as it is recently developed. In this wafer level CSP; resin layers and wirings are formed on a surface of a silicon wafer in which tiny transistors are fabricated. This silicon wafer is cut into an individual semiconductor device so as to form a semiconductor device.

In the conventional method of manufacturing a semiconductor device using a wafer level CSP, when a resin layer is formed on a surface of a silicon wafer, a resin layer is not formed in a portion which is diced so as to avoid loosing a resin layer and crack of an end area of a semiconductor device (See the Patent Document 1).

### Other Prior Art Documents

Some other prior art relating to the background of the present invention is disclosed in another patent document 1: International Patent Publication No. 01-071805 pamphlet (e.g. FIG.1 and FIG.14)

### Summary of the Invention

### Problem to Be Solved

In the conventional method of manufacturing a semiconductor device using a wafer level CSP ( the Patent Document 1 for example),however, a resin layer and a external terminal are formed close to the center of a semiconductor element and the external terminal is coupled to a wiring extended from an electrode formed in a circumference of the semiconductor device. In this case, wirings are formed only on a surface of a resin layer such that an area of portion in which wirings and external terminals are formed is small and it is difficult to form many external terminals and it is uneasy to realize high density of wirings and external terminals.

The present invention is intended to provide a semiconductor device and a method of manufacturing thereof in which wirings and external terminals can be formed with high density, a circuit substrate and an electronic apparatus in which the semiconductor device is installed.

### Means to Solve the Problem

A semiconductor device of the present invention comprises; a semiconductor element including a plurality of electrodes; a plurality of resin layers, a plurality of wirings electrically coupled to electrodes, and a plurality of external terminals electrically coupled to the wirings. A first wiring, a part of the wirings is formed at the bottom of a single resin layer or a plurality of multiple-deposited resin layers. A second wiring, excluding the part of the wirings is formed on the surface of a single resin layer or a plurality of multiple-deposited resin layers. A first wiring, a part of the wirings is formed at the bottom of a single resin layer or a plurality of multiple-deposited resin layers and a second wiring, excluding the part of the wirings is formed on the surface of a single resin layer or a plurality of multiple-deposited resin layers so that an area of a portion for forming a wiring can be expanded and many wirings and external terminals can be formed. Further, wirings are formed such as crossing overpass or underpass so as to enable an external terminal to be highly concentrated.

Further, in the semiconductor device of the present invention, a metal film made of the same material of the first wiring is formed on the surface of the electrode, which is not coupled to the first wiring. Forming a metal film made of the same material of the first wiring on the surface of the electrode, which is not coupled to the first wiring, can avoid oxidization or corrosion of the electrode.

Further, in the semiconductor device of the present invention, the first wiring is coupled to a external terminal located at least at the most outer circumference of the semiconductor elements, among the plurality of external terminals. A large stress is applied to an area close to outer circumference of a semiconductor element by thermal energy and others. Therefore, the first wiring which is relatively uneasy to disconnect is coupled to a external terminal located at least at the most outer circumference of the semiconductor elements, among the plurality of external terminals so as to avoid disconnection.

In the semiconductor device of the present invention, the semiconductor device is packaged with a chip size packaging method. The semiconductor device is packaged with a CSP method so that high density of wiring and external terminals can be realized by using the above structured wiring.

In the semiconductor device of the present invention, the external terminal is made of a solder ball. In the CSP semiconductor device, a solder ball is often used'for the external terminal. Thus, the above structured wiring can make the external terminal made of a solder ball with high concentration.

In the semiconductor device of the present invention, a bare hall is formed in the single resin layer or the plurality of multiple-deposited resin layers. A bare hall is formed in the single resin layer or the plurality of multiple-deposited resin layers so that first wiring formed on the bottom of the single resin layer or the plurality of multiple-deposited resin layers is easily coupled to the external terminal and coupling liability is improved.

In the semiconductor device of the present invention, the semiconductor device is manufactured by cutting the integration of semiconductor elements made of a silicon wafer with dicing. The semiconductor device is manufactured by cutting a silicon wafer in which tiny transistors and other are formed for example with dicing so that many semiconductor devices are obtained from a single silicon wafer.

Further, in the semiconductor device of the present invention, at least of one resin layer of the plurality of resin layers is formed in a region excluding cut portion with dicing the integration of the semiconductor elements. At least of one resin layer of the plurality of resin layers is formed in a region excluding cut portion with dicing the integration of the semiconductor elements so that crack of an end area of a semiconductor device and loosing a resin layer can be avoided.

In the semiconductor device of the present invention, at least of one resin layer is formed in a region in which the electrode is formed. The above one resin layer or multi layered resin layers is formed in a region in which the electrode is formed for example so that an area for forming external terminals can be expanded and many eternal terminals can be formed.

In a method of manufacturing a semiconductor device including; a semiconductor element including a plurality of electrodes; a plurality of resin layers, a plurality of wirings, and a plurality of external terminals coupled to the wirings, the method of manufacturing semiconductor device comprises the steps of; forming a first wiring, a part of the plurality of wirings; forming at least one resin layer or a plurality of multiple-deposited resin layers; and forming a second wiring, excluding the part of the wirings on the surface of a single resin layer or a plurality of multiple-deposited resin layers. A first wiring, a part of'the plurality of wirings is formed; at least one resin layer or a plurality of multiple -deposited resin layers is formed; and forming a second wiring, excluding the part of the wirings on the surface of a single resin layer or a plurality of multiple-deposited resin layers is formed so that an area of a portion for forming a wiring can be expanded to the both sides of a resin layer and many wirings and external terminals can be formed. Further, wirings are formed such as crossing overpass or underpass so as to enable an external terminal to be highly concentrated.

Further, in the semiconductor device of the present invention, a metal film made of the same material of the first wiring is formed on the surface of the electrode, which is not coupled to the first wiring. Forming a metal film made of the same material of the first wiring on the surface of the electrode, which is not coupled to the first wiring, can avoid oxidization or corrosion of the electrode.
Further, in the semiconductor device of the present invention, the first wiring is coupled to an external terminal located at least at the most outer circumference of the semiconductor elements, among the plurality of external terminals. A large stress is applied to an area close to outer circumference of a semiconductor element by thermal energy and others. Therefore, the first wiring which is relatively uneasy to disconnect is coupled to a external terminal located at least at the most outer circumference of the semiconductor elements, among the plurality of external terminals so as to avoid disconnection.

In the semiconductor device of the present invention, the semiconductor device is packaged with a chip size packaging method. The semiconductor device is packaged with a CSP method so that high density of wiring and external terminals can be realized by using the above structured wiring.

In the method of manufacturing a semiconductor device of the present invention, the external terminal is made of a solder ball. In the CSP semiconductor device, a solder ball is often used for the external terminal. Thus, the above structured wiring can make the external terminal made of a solder ball high concentration.

In the method of manufacturing a semiconductor device of the present invention, a bare hall is formed in the single resin layer or the plurality of multiple-deposited resin layers. A bare hall is formed in the single resin layer or the plurality of multiple-deposited resin layers so that first wiring formed on the bottom of the single resin layer or the plurality of multiple-deposited resin layers is easily coupled to the external terminal and coupling liability is improved.

In the semiconductor device of the present invention, the semiconductor device is manufactured by cutting the integration of semiconductor elements made of a silicon wafer with dicing. The semiconductor device is manufactured by cutting a silicon wafer in which tiny transistors and other are formed for example with dicing so that many semiconductor devices are obtained from a single silicon wafer.

Further, in the method of manufacturing a semiconductor device of the present invention, at least of one resin layer or the plurality of resin layers is formed in a region excluding cut portion with dicing the integration. At least of one resin layer is formed in a region excluding cut portion with dicing the integration of semiconductor elements so as to avoid crack of an end area of a semiconductor device and loosing a resin layer.

In the method of manufacturing a semiconductor device of the present invention, at least of one resin layer is formed in a region in which the electrode is formed. The above one resin layer or multi layered resin layers is formed in a region in which the electrode is formed for example so that an area for forming external terminals can be expanded and many external terminals can be formed.

In a circuit board of the present invention, the above mentioned semiconductor device is installed. The circuit board is provided with any of the above semiconductor devices in which the external terminals are formed with high concentration so as to realize miniaturization and high performance of the circuit board.

In an electronic apparatus of the present invention, any of the above mentioned semiconductor devices is installed. The electronic apparatus is provided with any of the above semiconductor device so as to realize miniaturization and high performance of the electronic apparatus.

### Brief Description of the Drawings

In the drawings
- **FIG. 1**: is an upper plane view and a longitudinal sectional view a first embodiment of the invention;
- **FIG. 2**: is an upper plane view showing a silicon wafer as an integration of semiconductor elements;
- **FIG. 3**: is a part view of an upper plane and a longitudinal sectional view of a second embodiment of the invention;
- **FIG. 4**: is a part view of an upper plane and a part view of a longitudinal section in a continued process followed by FIG.3;
- **FIG. 5**: is a part view of an upper plane and a part view of a longitudinal section in a continued process followed by FIG.4;
- **FIG.6**: is a perspective view of an example of a circuit substrate according to the embodiment 3 of the invention;
- **FIG.7**: is an example of an electronic apparatus of the embodiment 3 of the invention;

### Description of the Preferred Embodiments

### First Embodiment

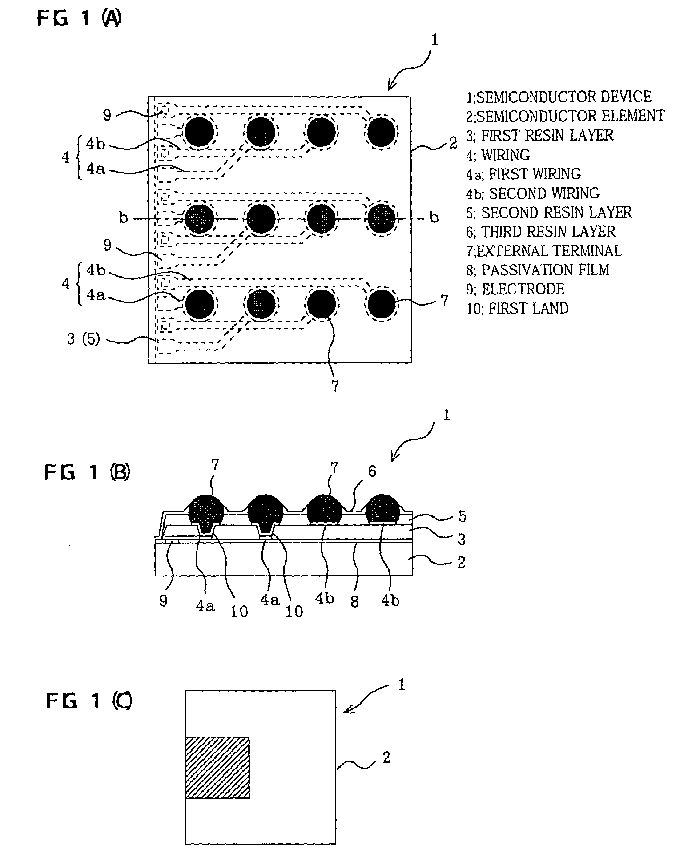

FIG. 1 is an upper plane view and a longitudinal sectional view a first embodiment of the invention. FIG.1A to 1B show a part of side view of a semiconductor device 1, namely a part corresponding to a shaded portion of FIG. 1C. In other portions of the semiconductor device 1, the structure shown in FIG. 1A is almost symmetrically formed. Here, some parts are shown as transparent in FIG 1A.

FIG. 1B is a longitudinal sectional view along the line b-b shown in FIG. 1A. The semiconductor device 1 of the embodiment I mainly comprises a first resin layer 3, a wiring 4, a second resin layer 5, a third resin layer 6 and an external terminal 7 on one surface of a semiconductor element 2. Here, a plurality of wirings 4 comprises a first wiring 4a and a second wiring 4b. The first wiring 4a is formed as a part on the first resin layer 3 and the surface of the semiconductor element 2. The second wiring 4b is formed as other wirings except the above part on the first resin layer 3 and the surface of the side of the external terminal 7. A passivation film 8 and an electrode 9 are formed on one surface of the semiconductor element 2 and the first wiring 4a is formed on the surface of the passivation film 8.

A electrode 9 is provided in a plurality of electrodes electrically coupled to a plurality of wirings 4. Namely, each of wirings 4 is provided with the external terminal 7 electrically coupled to the wirings 4 so as to electrically couple the external terminal 7 with the electrodes 9. Herein the embodiment 1, a third resin layer 6 is formed for resinforcing the external terminal 7. But, it is not exactly needed.

In the semiconductor element 2, many tiny transistors and others are formed by pre processing a silicon wafer. The first resin layer 3 and the external terminal 7 are formed on a silicon wafer and the silicon wafer is cut by dicing thereafter so as to form each semiconductor device 1. Thus, what a silicon wafer is diced into becomes a semiconductor device as it is. This is called as a wafer level CSP. The wafer level CSP is a kind of packaging method called as CSP and further advanced as miniaturization comparing the conventional CSP. Heresin the embodiment 1, silicon (mainly mono crystalline) is used as the semiconductor device 2. But other semiconductor materials such as Gallium Arsenide and others can be used.

A thin passivation film 8 and an electrode 9 made of Aluminum and others are formed on one surface of the semiconductor element 2 and the first wiring 4a and the first resin layer is formed on the surface of the passivation film 8. In the embodiment 1, a plurality of electrodes 9 are placed in the circumstance of the semiconductor element 2 and the first resin layer 3 is also formed on a part of electrodes 9. Thus, forming the first resin layer 3 can expand a region for forming the external terminal 7 and enables many external terminals 7 to be formed. Further, the first resin layer 3 is not formed at the outer circumstance of the semiconductor element 2. As the material for the first resin layer 3, polyimide resin, silicon denaturation of polyimide resin, epoxy resin, silicon denaturation of epoxy resin, phenolic resin, acrylic resin, benzocyclo butene (BCB) and poly benz oxazole (PBO) are used.

As described above, a part of the wirings 4 is the first wiring 4a and other part except the previous part is the second wiring 4b. The first wiring 4a is coupled to a part of the plural of the electrodes 9 and formed on the surface of the first resin layer 3 which is the side of the semiconductor device 2. The second wiring 4b is coupled to the electrodes 9 which are not coupled to the first wiring 4a and formed on the surface of the first resin layer 3 which is the side of the external terminal 7. Here, the second wiring 4b is coupled to electrodes 9 via a second bare hall (explained in a second embodiment in detail) formed on the electrodes 9 of the first resin layer 3 and extended up from the second bare hall to the surface which is the side of the external terminal 7 of the first resin layer 3. Further, in other part coupled to the electrodes 9 of the first wiring 4a, a first land 10 (explained in a second embodiment in detail) for connecting the external terminal 7 and the wiring 4a is formed. If all wirings 4 are formed on the surface which is the side of the external terminal 7 of the resin layer 3 for example, an area for forming the wirings 4 becomes small and the wirings 4 can not be crossed each other overpass or underpass so that the wiring 4 and external terminal 7 can not be formed with high concentration. On the other hand, in the embodiment 1, the wiring 4 is formed on the both surfaces of the first resin layer 3 so as to realize the wiring 4 and the external terminal 7 with high concentration. [0031]

The first wiring 4a is made of multi layers including a layer of an alloy of titan and tungsten and a layer of cupper. The second wiring 4b is also formed by the same process for the first wiring 4a. But, it is preferable that it is formed by copper plating. In the embodiment 1, the first resin layer 3 is formed between the first wring 4a and the second wiring 4b. It is prefer that a plurality of resin layers are formed and other material is interposed. In the embodiment 1, the first wiring 4a is formed on the surface of the passivation film 8. It is preferable that other resin film is formed between the first wiring 4a and the semiconductor element 2.

A second resin layer 5 is formed on the surface of the semiconductor element 2 comprising the first wiring 4a, the first resin layer 3 and the second wiring 4b. The second resin layer 5, however, is not formed in the outer circumstance of the semiconductor element 2, on the first land 10 and a region (a second land explained in the embodiment 2 in detail) where the external terminal 7 of the wiring 4b is formed. The second resin layer 5 is not formed in the outer circumstance of the semiconductor element 2,so as to avoid crack of an end area of the semiconductor device 1 and loosening a resin layer by avoiding the area cut with dicing when the semiconductor element 1 is cut from a silicon wafer with dicing. Here, as the material for the second resin layer 5, the same material for the first resin layer may be used or a different material thereof may be used.

The external terminal 7 made of a solder ball is formed on the first land 10 and the second land (explained in the second embodiment in detail). The external terminal 7 is used for connecting the semiconductor device 1 to the circuit board and made of a lead- free solder for example. Further, the third resin layer 3 may be formed on the surface and the side of the second resin layer 5. The third resin layer 6 is formed mainly for reinforcing the external terminal 7 so that a circumferential area of the external terminal 7 rises like small hill. Further, the third resin layer 6 is formed exposing a part of the external terminal 7. Here, as the material for the third resin layer 6, the same material for the first resin layer 3 may be used or a different material thereof may be used. It is preferable that elasticity of the first resin layer 3, the second resin layer 5 and the third resin layer 6 becomes lowered in this order. Thus, a resin layer having lower elasticity from the semiconductor element 2 to the external element 7 is formed so as to effectively relax the stress and others applied to the external terminal 7 by thermal stress.

In the embodiment 1, the first wiring 4a, a part of the plural wirings 4 is formed at the bottom of the first resin layer 3 and the second wiring 4b, excluding the above part of the wirings 4 is formed on the surface of the first resin layer 3 so that an area of a portion for forming wirings 4 can be expanded and many wirings 4 and external terminals 7 can be formed. Further, the first wiring 4a is formed on the surface of the passivation film 8 and there is no step so as to enable fine wiring.

### Second Embodiment

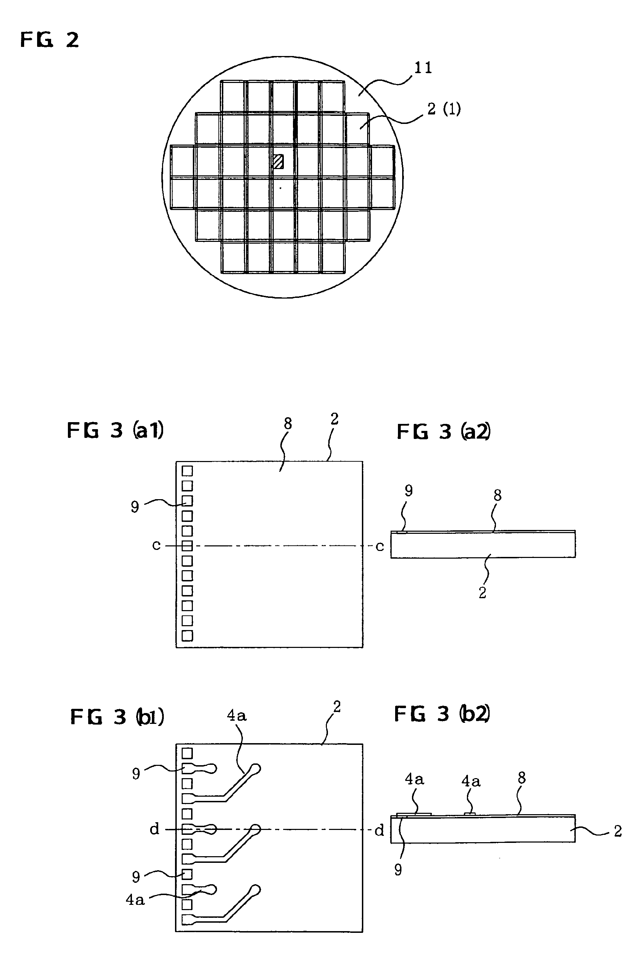

FIG. 2 is an upper plane view showing a silicon wafer as an integration of semiconductor elements 2. After completing the manufacturing process of a semiconductor device shown in FIG.3 through FIG. 5, the silicon wafer 11 is cut by dicing so as to form each semiconductor device]. FIG.3 through FIG. 5 show a part close to the side of a semiconductor element 2, a shaded portion in FIG.2. Here the processes shown in FIG.3 through FIG.5 are completed for other portions of the semiconductor device 1.

FIG. 3, 4 and 5 are a partial plane view and partial longitudinal cross section showing manufacturing process for a semiconductor device of the embodiment 2 of the invention. Here, the manufacturing method shown in the embodiment 2 is to manufacture the semiconductor device shown in the embodiment 1. In FIG.3, 4 and 5, the second resin layer 5, the third resin layer 6 are disclosed with see-through similar to FIG. IA. First, the passivation film 8 and the electrode 9 are formed on a silicon wafer provided with many tiny transistors via preprocessing (FIG.3 (al)). FIG. 3 (a2) is a longitudinal sectional view along the line c-c shown in FIG. 3 (al). The passivation film 8 is formed in an area except a portion of electrodes 9 on a side surface of a semiconductor element 2. Electrodes 9 are formed in outer circumstance of the semiconductor element 2.

Then, the first wiring 4a is formed as coupled to a part of electrodes 9 on the semiconductor element 2 (FIG.3 (bl )). FIG. 3 (b2) is a longitudinal sectional view along the line d-d shown in FIG. 3 (b1). At this time, it is preferable that another end of a part of the first wiring 4a coupled to electrodes 9 has a little swollen shape. Further, a metal film may be formed on the surface of the electrodes 9 which are not coupled to the first wiring 4a during the process of FIG.3 (b1) to avoid oxidization or corrosion. The material for the metal film is the same for the first wiring 4a. It is preferable that the first wiring 4a is coupled to external terminal 7 and electrodes 9 in the outer circumference of the semiconductor element 2. The external terminal 7 of the wiring 4 is easily disconnected by large stress such as thermal stress in the outer circumference of the semiconductor element 2. The first land, however, is formed as described later so that it is uneasy to disconnect the connecting portion of the external terminal 7 due to relaxation of the stress. In the embodiment 2, as shown in FIG.3 (b1), it is preferable that the external terminal 7 located at the outer circumference of the semiconductor device 2 and the external terminal 7 located at further inside of it are coupled to the first wiring 4a. The first wiring 4a is formed by forming an alloy layer of titan and tungsten and a cupper layer on the surface of the passivation film 8 with sputtering for example, coating a resist film with a predetermined shape (not shown) thereafter, leaving it in the area for the first wiring 4a with etching and removing the resist layer.

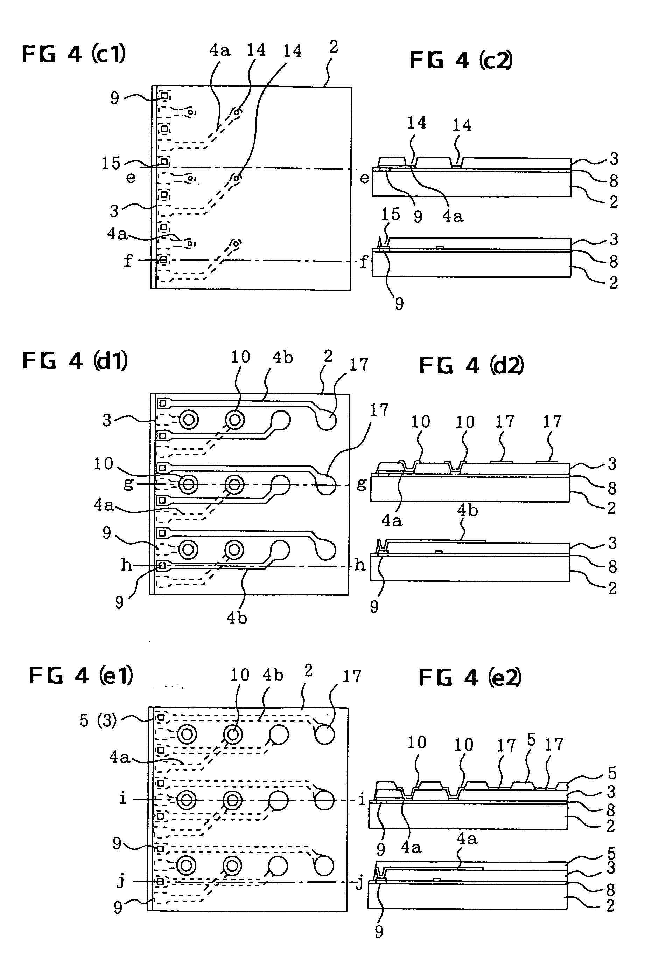

Further, the first resin layer 3 is formed on the surface of the passivation film 8 in which the wiring 4a is formed during the process of FIG.3 (bl) (FIG.4 (cl)) At this time, the first resin layer 3 is also formed on a part of the first wiring 4a and electrodes 9. Thus, forming the first resin layer 3 on a part of electrodes 9 can expand a region for forming the external terminal 7 and enables many external terminals 7 to be formed. Further, the first resin layer 3 is not formed at the outer circumference of the semiconductor element 3. Further, the first resin layer 3 may not be formed on a part of electrodes 9. FIG. 4 (c2) is a longitudinal sectional view along the lines e-e and f-f shown in FIG. 4 (cl). A first bare hall 14 is formed in an end part of the fist resin layer 3 in which the first wiring 4a is coupled to electrodes 9. A second bare hall 15 is formed in a upper part of the resin layer 3 in which the first wiring 4a is not coupled to electrodes 9.

The second wiring 4b is formed on the surface of the first resin layer 3 so as to couple the first wiring 4a with electrodes 9 and the first land 10 is formed on a part of the first bare hall 14 (FIG.4 (dl)) At this time, another end of a part of the second wiring 4b coupled to electrodes 9 has a little swollen shape to be the second land 17 in which the external terminal 7 will be formed. The second wiring 4b is coupled to electrodes 9 via the second bare hall 15. FIG. 4 (d2) is a longitudinal sectional view along the lines g-g and h-h shown in FIG. 4 (dl ). The second wiring 4b is also formed by the same process for the first wiring 4a. But, it is preferable that copper plating is added over the layer of titan and tungsten alloy and the copper layer. Further, the first land 10 is formed similar to the process for forming the second wring 4b. [0040]

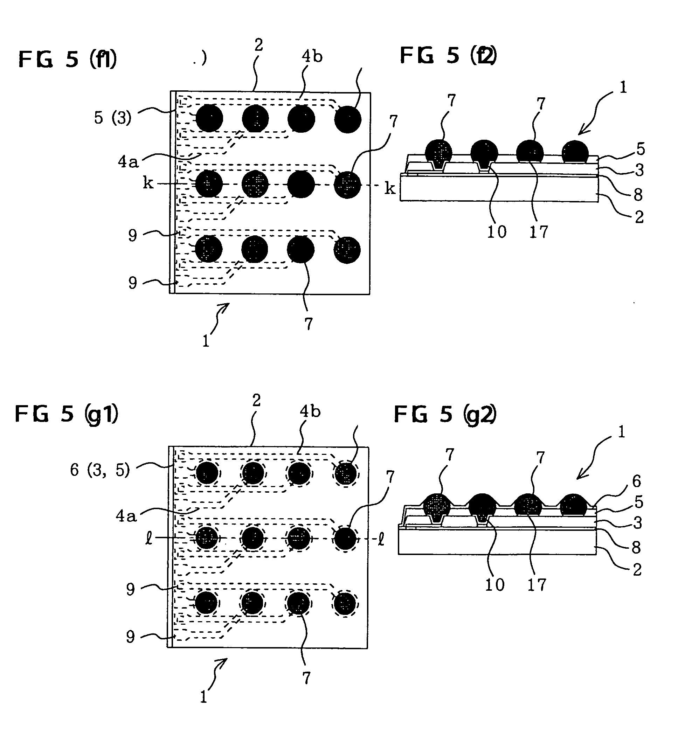

The second resin layer 5 is formed on the surface of the first resin layer 3 and the second wiring 4b (FIG.4 (el)) At this time, the second resin layer 5 is not formed at the outer circumference of the semiconductor element 2, on the first land 10 and second land 1 7(FIG.4 (e2).) FIG. 4 (e2) is a longitudinal sectional view along the lines i-i and j -j shown in FIG. 4 (el). A part of the first land 10 in which the second resin layer 5 is not formed may be expanded so as to increase liability of connection of the external terminal 7. The external terminal 7 made of a solder ball is formed in the area of the first land 10 and the second land 17 (FIG.5 (fl).) The external terminal 7 is made of lead free solder for example and formed by a solder ball transferring, paste printing and plating. FIG. 5 (f2) is a longitudinal sectional view along the line k-k shown in FIG. 5 (fl).

Further, the third resin layer 3 is formed on the surface and the side of the second resin layer 5 (FIG.(gl).) FIG. 5 (g2) is a longitudinal sectional view along the line 1-1 shown in FIG. 5 (gl). In this case, the third resin layer 6 is formed exposing a part of the external terminal 7. Further, the third resin layer 6 does not necessarily need. Finally, after completing the manufacturing processes shown in FIG. 5 (fl) through FIG. 5 (gl), the silicon wafer is cut by dicing so as to form each semiconductor device 1. In the above manufacturing processes, the first resin layer 1 and the second resin layer 5 are not formed in the area in which a silicon wafer as integration of the semiconductor element 2 is diced so that these resin layers are not cut so as to avoid cracking the end of the semiconductor element 2 and removing these resin layers.

In the embodiment 2, the first wiring 4a, a part of the plural wirings 4 is formed and the first resin layer 3 is formed on the surface of the first wiring 4a thereafter and the second wiring 4b, excluding the above part of the wirings 4 is formed on the surface of the first resin layer 3. An area of a part for forming wirings 4 is expanded to both surfaces of the first resin layer 3 so that many wirings 4 and external terminals 7 can be formed. Further, wirings are formed such as crossing overpass or underpass so as to enable an external terminal to be highly concentrated.

### Third Embodiment

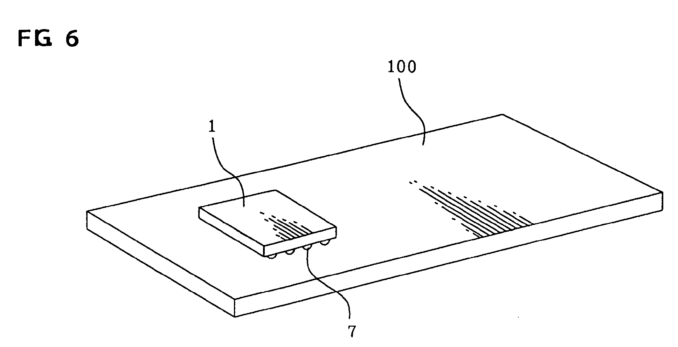

FIG. 6 is a perspective view schematically showing an example of a circuit board according to a third embodiment of the invention. In a circuit board 100 shown in FIG. 6, the semiconductor device according to the first embodiment of the invention is mounted. The circuit board 100 is made of a glass epoxy substrate and wiring patterns such as copper and others are formed in advance. The external terminal 7 of the semiconductor device is coupled to the circuit board 100 so as to be electrically conducted and perform a predetermined processing (data processing for example).

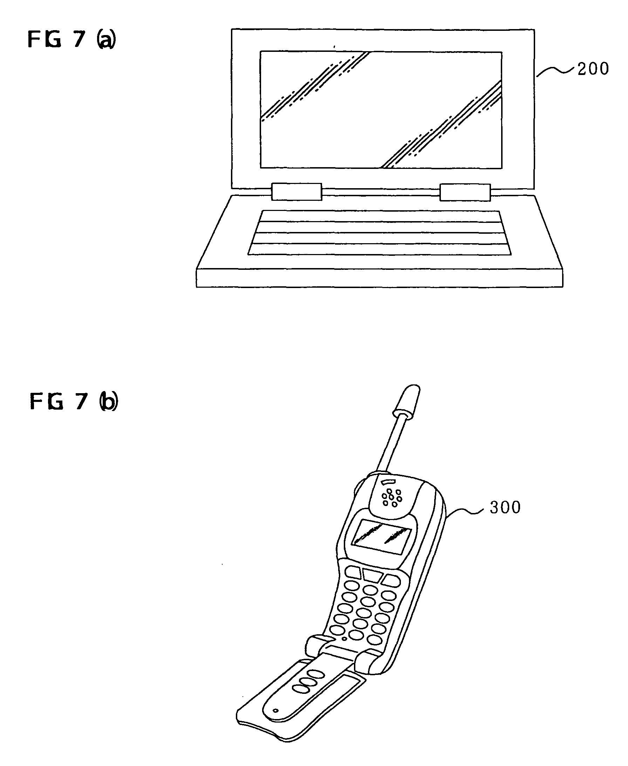

FIG. 7 is an example of an electronic apparatus according to a third embodiment of the invention. An electronic apparatus shown in FIG. 7 has the semiconductor devicel according to the first embodiment of the invention. FIG.7A shows an example in which the semiconductor device 1 is applied to the personal computer 200 and FIG.7B is an example in which the semiconductor device I is applied to the cellar phone 300. Here, the semiconductor device 1 shown in the first embodiment 1 and the semiconductor device 1 shown the manufacturing method of the second embodiment 2 can be applied to other electronic devices for home use.

### List of Reference Numerals

- 1;: semiconductor device,
- 2;: semiconductor element,
- 3;: first resin layer,
- 4;: wiring,
- 4a;: first wiring,
- 4a;: second wiring,
- 5;: second resin layer,
- 6;: third resin layer,
- 7;: external terminal,
- 8;: passivation film,
- 9;: electrode,
- 10;: first land,
- 11;: silicon wafer,
- 14;: first bare hall,
- 15;: second bare hall,
- 17;: second land,
- 100;: circuit board,
- 200;: note type personal computer,
- 300;: cellar phone,

## Claims

1. A semiconductor device comprising:
a semiconductor element including a plurality of electrodes;
a plurality of resin layers;
a plurality of wirings electrically coupled to the electrodes, and
a plurality of external terminals electrically coupled to the wirings, wherein
a first wiring, a part of the wirings, is formed at the bottom of a single resin layer or a plurality of multiple-deposited resin layers, wherein
a second wiring , excluding the part of the wirings, is formed on the surface of a single resin layer or a plurality of multiple-deposited resin layers.

2. A semiconductor device according to claim 1, wherein a metal film made of the same material of the first wiring is formed on the surface of the electrode which is not coupled to the first wiring.

3. A semiconductor device according to claim 1 or 2, wherein the first wiring is coupled to a external terminal located at least at the most outer circumference of the semiconductor elements, among the plurality of external terminals.

4. A semiconductor device according to claim 1 through claim 3, wherein the semiconductor device is packaged with a chip size packaging method.

5. A semiconductor device according to claim 1 through claim 4, wherein the external terminal is made of a solder ball.

6. A semiconductor device according to claim 1 through claim 5, wherein a bare hall is formed in the single resin layer or the plurality of multiple-deposited resin layers.

7. A semiconductor device according to claim 1 through claim 6, wherein the semiconductor device is manufactured by cutting the integration of semiconductor elements made of a silicon wafer with dicing.

8. A semiconductor device according to claim 7, wherein at least of one resin layer or the plurality of resin layers is formed in a region excluding cut portion with dicing the integration.

9. A semiconductor device according to claim 1 through claim 8, wherein at least one resin layer of the plurality of resin layers is formed in a region in which the electrode is formed.

10. A method of manufacturing a semiconductor device including: a semiconductor element including a plurality of electrodes; a plurality of resin layers, a plurality of wirings, and a plurality of external terminals coupled to the wirings, the method of manufacturing semiconductor device comprising:
forming a first wiring, a part of the plurality of wirings;
forming at least a single resin layer or a plurality of multiple-deposited resin layers thereafter; and
forming a second wiring, excluding the part of the wirings, on the surface of the single resin layer or the plurality of multiple-deposited resin layers.

11. A method of manufacturing a semiconductor device according to claim 10, further comprising:
forming a metal film made of the same material of the first wiring on the surface of the electrode which is not coupled to the first wiring.

12. A method of manufacturing a semiconductor device according to claim 10 or 11, further comprising:
connecting the first wiring to a external terminal located at least at the most outer circumference of the semiconductor elements, among the plurality of external terminals.

13. A method of manufacturing a semiconductor device according to any of claim 10 through 12, further comprising:
packaging the semiconductor device with a chip size packaging method.

14. A method of manufacturing a semiconductor device according to any of claims 10 through 13, wherein the external terminal is made of a solder ball.

15. Method of manufacturing a semiconductor device according to any of claim 10 through 14, further comprising the step of forming a bare hall in the single resin layer or the plurality of multiple-deposited resin layers.

16. A method of manufacturing a semiconductor device according to any of claim 10 through 15, further comprising the step of manufacturing the semiconductor device by cutting the integration of semiconductor elements made of a silicon wafer with dicing.

17. A method of manufacturing a semiconductor device according to any of claim 10 through 16, wherein at least one resin layer of the plurality of resin layers is formed in a region excluding cut portion with dicing the integration. ,

18. A method of manufacturing a semiconductor device according to any of claim 10 through 17, wherein at least one resin layer is formed in a region in which the electrode is formed.

19. A circuit substrate including the semiconductor device according to any of claims 1 through 9.

20. An electronic apparatus including the semiconductor device according to any of claims 1 through 9.
